# EUROPEAN PATENT SPECIFICATION

(11) **EP 2 966 952 B1**
(45) Date of publication and mention of the grant of the patent: **19.06.2019**
(21) Application number: 13877234.8
(22) Date of filing: 05.03.2013
(51) Int. Cl.: H05K 13/00

(54) **BACKUP PIN AND AUTOMATED BACKUP-PIN SWAP SYSTEM**
SICHERUNGSSTIFT UND STIFTWECHSELSYSTEM MIT AUTOMATISIERTER SICHERUNG
BROCHE DE RACCORDEMENT DE SECOURS ET SYSTÈME AUTOMATISÉ D'ÉCHANGE DE BROCHE DE RACCORDEMENT DE SECOURS

(43) Date of publication of application: 13.01.2016
(73) Proprietor: FUJI Corporation, Chiryu Aichi (JP)
(72) Inventor: KAWAI, Hidetoshi, Chiryu, Aichi (JP); MIZUNO, Takayuki, Chiryu, Aichi (JP); ITO, Hidetoshi, Chiryu, Aichi (JP); TANAKA, Keita, Chiryu, Aichi (JP)
(74) Representative: Grünecker Patent- und Rechtsanwälte PartG mbB
(86) International application number: PCT/JP2013/056038
(87) International publication number: WO 2014/136212

(56) References cited:
- JP-A- H11 195 899
- JP-A- 2010 171 149
- JP-U- H0 652 197
- US-A- 5 218 753
- US-A1- 2011 268 346

## Description

### Technical Field

The present invention relates to a backup pin that supports, from below, a circuit board on which a component is mounted at a component mounting station of a component mounting machine, and an automatic backup pin exchange system.

### Background Art

With recent component mounting machines, because component mounting boards are becoming thinner and easier to bend, a circuit board is supported from below by backup pins to be prevented from bending when a component is mounted on the circuit board. In addition, in order to meet a recent demand for highly dense mounting and miniaturization, there is an increased demand for a double-sided mounting boards for which components are mounted on both surfaces of the circuit board. In a case where the double-sided mounting board is manufactured by the component mounting machine, components are first mounted on one surface of the board. Then, the board is turned upside down and is loaded again into the component mounting machine and components are mounted on the remaining surface of the board.

When a component is mounted on the remaining surface of the board and a backup pin supporting the board from below comes into contact with a formerly mounted component on an underside of the board, there is a possibility that the formerly mounted component is damaged or the board is pushed upward. Therefore, as disclosed in PTL 1 (JP-A-2004-335973), the backup pin is formed of a soft elastic material such as urethane such that, when the pin tip comes into contact with the formerly mounted component, the pin tip is elastically deformed and the formerly mounted component is prevented from being damaged or the board is prevented from being pushed upward. In general, such a backup pin which is elastically deformable is referred to as a "soft pin" and a backup pin which is not elastically deformed is referred to as a "hard pin".

In a case where the double-sided mounting board is manufactured using the soft pin, an operator uses a pin block in which many soft pins are integrally formed on a base plate in the shape of a matrix and picks unnecessary soft pins off the pin block based on the arrangement of the formerly mounted components for each type of board to be produced. Alternatively, as disclosed in PTL 1, many attachment holes are formed on a backup plate (pin support plate) in the shape of a matrix and a convex fitting portion is formed on the lower end of the soft pins to fit to the attachment hole such that the operator selects an attachment hole to which the convex fitting portion on the lower end of the soft pin fits and attaches the soft pins to the backup plate based on the arrangement of the formerly mounted components for each type of board to be produced.

In a case of the hard pin which is used when manufacturing a single-sided mounting board with which a component is mounted on only one surface, as disclosed in PTL 2 (Japanese Patent No. 2792931), many attachment holes are formed on a backup plate in the shape of a matrix and an operator selects an attachment hole to which the convex fitting portion on the lower end of the hard pin fits and attaches the hard pin to the backup plate based on the type of board to be produced.
US 2011/0268446 A1 discloses a back-up pin device comprising a base, at least one support pin erected upright on the base portion to support the board by contacting an upper end thereof with an under surface of the board.
US 5 218 753 A discloses an apparatus that includes a back-up pin stocker provided in the vicinity of a base plate, which stores spare back-up pins being not used. A replacing unit is provided attached to the mounting head to be movable between the base plate and the back-up pin stocker together with the mounting head so that the back-up pins held on the base plate can be replaced with the back-up pins stored in the back-up pin stocker.

### Citation List

### Patent Literature

PTL 1: JP-A-2004-335973
PTL 2: Japanese Patent No. 2792931

### Summary of Invention

### Technical Problem

However, in the related art described above, the hard pins and the soft pins have to be separately assorted and controlled such that burdensome control of the backup pins and a high control cost are drawbacks.

In order to solve the problems, the invention of the present application provides a backup pin and an automatic backup pin exchange system for which backup pin control is easy and with which a control cost can be reduced.

### Solution to Problem

In order to solve the problems described above, a backup pin of the present invention is configured to include a holder portion on the lower side thereof and a pin portion on the upper side thereof which is interchangeably held in the holder portion such that the backup pin is used with a pin portion selected from a plurality of types of pin portions formed of different materials and/or having different shapes being held in the holder portion. In this case, since the plurality of types of backup pins formed of different materials or having different shapes share the holder portion, it is possible to easily control the backup pins such that a control cost can be reduced.

In this case, examples of the pin portion which can be held in the holder portion may include a soft pin portion formed of a soft elastic material or a hard pin portion formed of a hard material, may include a plurality of types of soft pin portions or hard pin portions which are different from each other only in shape and are formed of the same material, or may additionally include a plurality of types of soft pin portions formed of different soft elastic materials (elastic coefficient).

In addition, a gripping portion which is gripped by a chuck held on a mounting head of the component mounting machine may be formed on the holder portion of the backup pin of the present invention. In this case, the backup pin is reliably gripped by the chuck of the mounting head of the component mounting machine such that it is possible to automatically dispose the backup pin at any position.

As in PTL 1 and PTL 2, in a structure for attaching the backup pins to the backup plate according to the present invention, many attachment holes are formed on the backup plate in the shape of a matrix and a convex fitting portion which fits to the attachment hole may be formed on the holder portion of the backup pin, an attachment hole in which the convex fitting portion of the holder portion fits may be selected according to the type of the board to be manufactured, and the backup pin may be attached to the backup plate.

However, in the attachment structure, the arrangement of the backup pins on the backup plate is limited to the positions of the attachment holes and it is not possible to freely arrange the positions of the backup pins.

Hence, the backup plate is formed of a magnetic material and the backup pin is configured to include a magnet that holds the holder portion on the backup plate due to a magnetic force, in the holder portion of the backup pin. In this case, since it is possible to attach the backup pin to any position on the backup plate due to the magnetic force of the magnet, the backup pin is freely disposed on the backup plate.

In addition, an automatic backup pin exchange system includes: a stocker that accommodates the backup pin according to the present invention; a backup plate on which the backup pin is mounted; a chuck held on a mounting head of the component mounting machine; and a control means for controlling movement operations of the mounting head and an opening/closing operation of the chuck. A plurality of backup pins on which different types of pin portions are held may be accommodated in the stocker. The control means may control an operation of gripping the backup pin on the backup plate by the chuck and accommodating the backup pins in the stocker, and an operation of gripping a predetermined backup pin by the chuck from the plurality of backup pins accommodated in the stocker and mounting the backup pin at a predetermined position on the backup plate. In this case, it is possible for an operation of selecting a backup pin accommodated in the stocker and mounting the backup pin on the backup plate to be automatically performed.

In this case, the stocker may be disposed outside a conveyor that conveys the circuit board; however, when the stocker is disposed outside the conveyor, the mounting head has to travel across the rail of the conveyor when the backup pin in the stocker is gripped by the chuck of the mounting head of the component mounting machine and is mounted on the backup plate. Thus, the mounting head travels a long distance and a transfer operation of the backup pin takes time. Meanwhile, when the stocker is disposed inside the conveyor, there is a possibility that a circuit board will be above the stocker. Therefore, there is a possibility that a backup pin accommodated in the stocker will interfere with a formerly mounted component on the circuit board.

In order to solve these problems, the stocker may be provided on a side edge section of the backup plate, which is positioned inside the conveyor, in a position that is lower than the backup plate. In this manner, even when the stocker is provided on the side edge section of the backup plate which is positioned inside the conveyor, it is possible to prevent the backup pins accommodated in the stocker from interfering with formerly mounted components on the circuit board. Further, when the stocker is provided on the side edge section of the backup plate which is positioned inside the conveyor, the mounting head does not have to travel across the rail of the conveyor and the mounting head can travel a short distance such that it is possible to shorten the time required for the transfer operation of the backup pins.

In this case, in the component mounting machine in which one of the rails on both sides of the conveyor is set as a reference rail having a fixed position and the other rail is set as a movable rail which moves in a width direction of the circuit board over a width thereof, the stocker may be provided on the reference rail side. Since the circuit board is supported by the reference rail, the backup pin does not have to be disposed in the vicinity of the reference rail on the backup plate. Thus, the stocker is provided on the reference rail side and it is possible to provide the stocker on the backup plate substantially with no limitation on the arrangement of the backup pins on the backup plate.

In addition, in the component mounting machine that includes an imaging device which images an imaging target object from above, backup pins accommodated in the stocker may be imaged using the imaging device and types of the backup pins may be identified through image processing. In this manner, it is possible to reliably prevent wrong types of backup pins from being mistakenly mounted on the backup plate.

### Brief Description of Drawings

Fig. 1 is a perspective view illustrating the assembly of two types of pin portions and a holder portion according to an example of the present invention.
Fig. 2 is a perspective view illustrating a component mounting station of a component mounting machine.
Fig. 3(a) is a longitudinal sectional view of a portion around a stocker, illustrating a state at the time of unclamping a board and Fig. 3(b) is a longitudinal sectional view of a section around the stocker, illustrating a state at the time of clamping a board.
Fig. 4 is a perspective view illustrating an arrangement of the stocker.

### Description of Embodiments

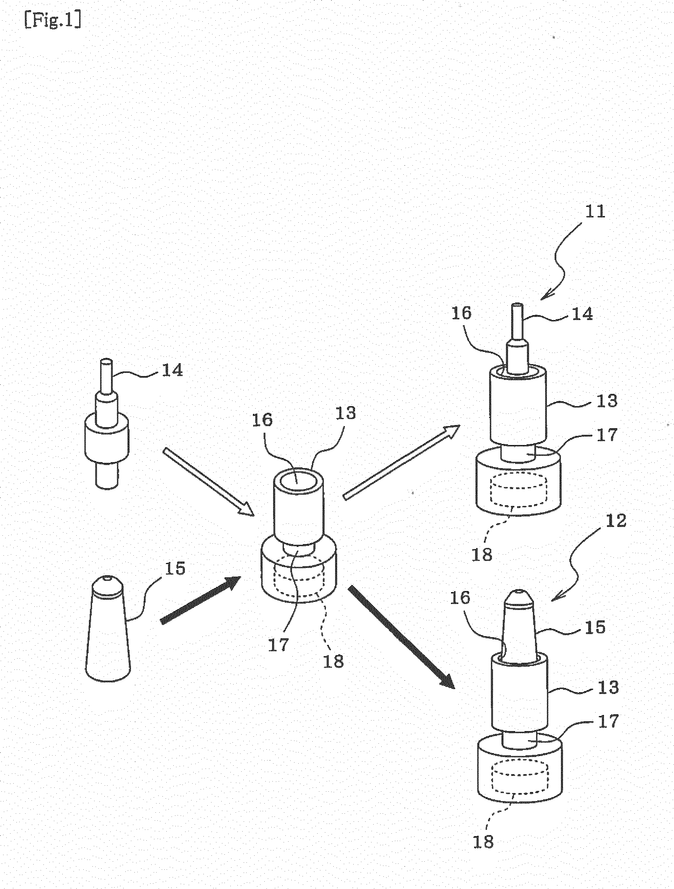

Hereinafter, an example of embodiments of the present invention will be described. First, configurations of two types of backup pins 11 and 12 will be described using Fig. 1.

The backup pins 11 and 12 are configured to have a holder portion 13 on the lower side thereof and pin portions 14 and 15 on the upper side thereof which are interchangeably held in the holder portion 13, respectively. The pin portions 14 and 15 are formed of different materials and/or have different shapes. According to the present example, one pin portion 14 is a multi-step cylindrical hard pin portion formed of a hard material such as metal or plastic and the other pin portion 15 is a soft pin portion formed of a soft elastic material such as urethane and rubber, for which a tapered shape is formed, in which the higher the portion is, the smaller the diameter becomes, and a round (dome-like) top portion thereof is formed. The hard and soft pin portions 14 and 15 are formed such that the maximum outer diameter on their lower side is the same.

The holder portion 13 is formed of a hard material such as metal or plastic and a fitting hole 16 having a circular shape in a cross-sectional view is formed on the upper side of the holder portion to fit to the lower side of the pin portion 14 or 15 and to hold the pin portion 14 or 15 upward. The lower side of one of the two types of hard and soft pin portion 14 or 15 is fit in the fitting hole 16 of the holder portion 13 and the pin portion 14 or 15 is held in the holder portion 13 upward such that the backup pin 11 or 12 is assembled. In the following description, the backup pin 11 that holds the hard pin portion 14 is abbreviated to a "hard pin" and the backup pin 12 that holds the soft pin portion 15 is abbreviated to a "soft pin", in some cases. The hard pin 11 may be used in a case of backup for a thick (highly rigid) circuit board. The soft pin 12 may be used in a case of backup for a circuit board on which vibration suppression needs to be performed. In addition, the soft pin 12 may be used when supporting a formerly mounted component. The hard pin 11 and the soft pin 12 may be used in combination.

In addition, a recessed annular groove shaped gripping portion 17 is formed on an outer circumferential section of the holder portion 13 to be gripped by a chuck (not illustrated) which is held on a mounting head of a component mounting machine. A magnet 18 that holds the holder portion 13 on a backup plate 30 to be described below due to a magnetic force is provided on the lower side of the holder portion 13.

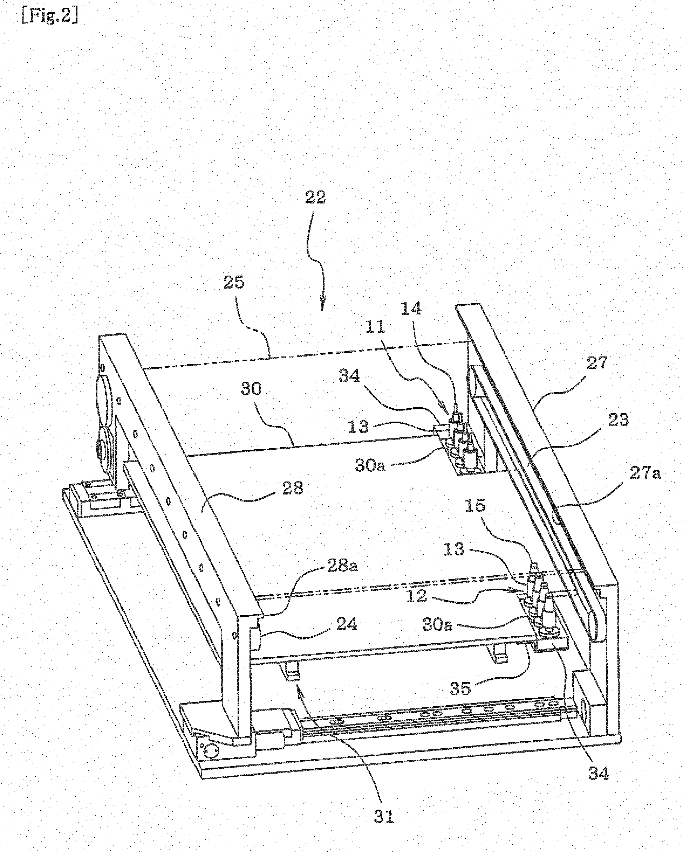

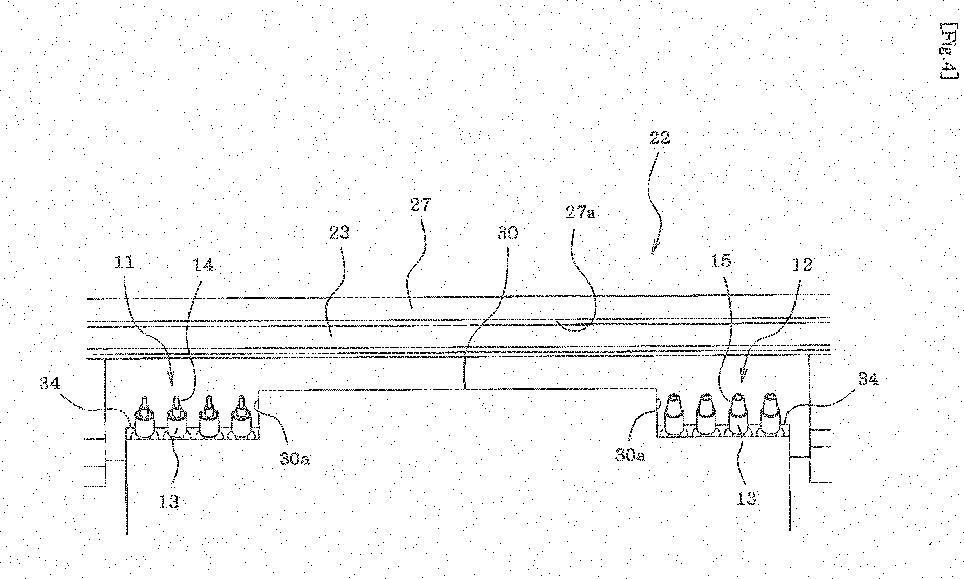

Next, a configuration of a component mounting station 22 of the component mounting machine will be described using Fig. 2 to Fig. 4. The component mounting station 22 is a place at which a component is mounted on a circuit board 25 conveyed on conveyors 23 and 24, by the mounting head (not illustrated) of the component mounting machine. The conveyors 23 and 24 are disposed parallel to a conveyance direction of the circuit board 25 such that both the right and left side sections of the circuit board 25 are mounted thereon and are conveyed. A rail 27 that holds the conveyor 23 on the right side is a reference rail having a fixed position and a rail 28 that holds the conveyor 24 on the left side is a movable rail which moves in a width direction of the circuit board 25 depending on the width thereof.

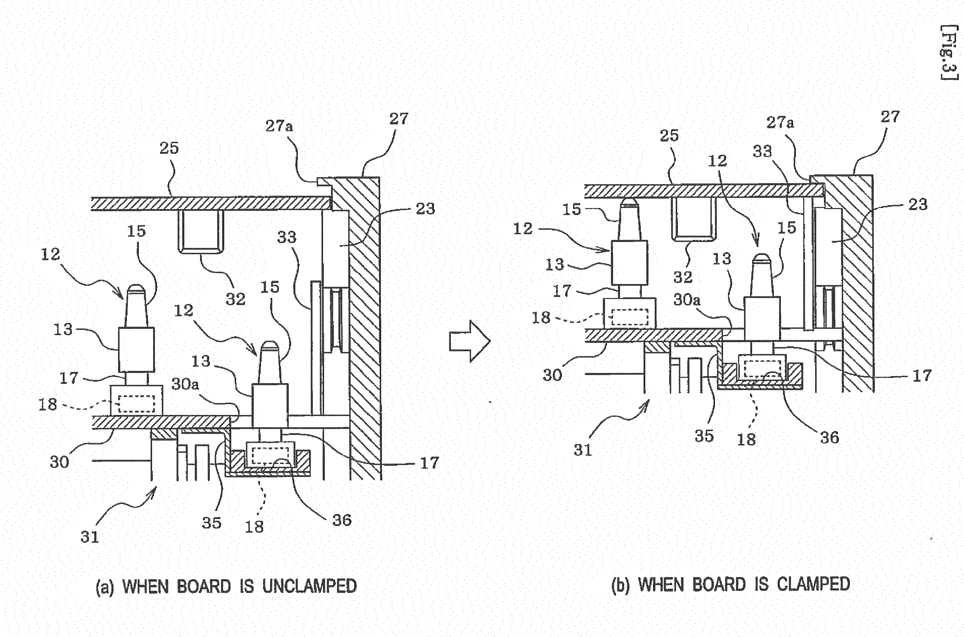

The backup plate 30 on which the backup pins 11 and 12 are mounted is provided horizontally at the component mounting station 22. The backup plate 30 is formed of a magnetic material such as iron such that the backup pins 11 and 12 are attached to and held on the backup plate 30 by the magnet 18 of the holder portion 13. As illustrated in Fig. 3, the backup plate 30 is configured to be lifted and lowered by a lifting and lowering mechanism 31, the lower limit position at the time of a lowering operation becomes a board unclamping position illustrated in Fig. 3(a) and the upper limit position at the time of a lifting operation becomes a board clamping position illustrated in Fig. 3(b).

As illustrated in Fig. 3(a), in a state in which the backup plate 30 is lowered to the board unclamping position, the tops of the backup pins 11 and 12 on the backup plate 30 are positioned lower than the underside of the circuit board 25 on the conveyors 23 and 24. In a case where a formerly mounted component 32 is mounted on the underside of the circuit board 25 on the conveyors 23 and 24, the top of the soft pin 12 on the backup plate 30 is set to be lower than the lower end of the formerly mounted components 32 on the underside of the circuit board 25.

As illustrated in Fig. 3(b), in a case where the backup plate 30 is lifted to the board clamping position, the tops of the backup pins 11 and 12 on the backup plate 30 come into contact with the underside of the circuit board 25 on the conveyors 23 and 24, support the circuit board 25 from below, and prevent the circuit board 25 from bending. When the backup plate 30 is lifted to the board clamping position, a clamping member 33 positioned inside the conveyors 23 and 24 is lifted such that both of the right and left side sections of the circuit board 25 are interposed and clamped between flanges 27a and 28a which are provided on the upper inner side of the rails 27 and 28 and the clamping member 33.

As illustrated in Fig. 2 to Fig. 4, cutout sections 30a are formed in a side edge section of the backup plate 30 in the vicinity of and inside the reference rail 27. Stockers 34 that accommodate the plurality of backup pins 11 and 12 are attached through attachment tool 35 (refer to Fig. 3) to an edge portion of the cutout sections 30a. The stockers 34 are formed such that the plurality of backup pins 11 and 12 can be arranged in parallel with the inide of the reference rail 27. A plurality of recessed accommodation portions 36 (refer to Fig. 3) in which the holder portions 13 of the plurality of backup pins 11 and 12 are fitted and accommodated, respectively, are formed on the top surfaces of the stockers 34 in a row and the backup pins 11 and 12 which are accommodated in the recessed accommodation portions 36, respectively, are exposed on the upper side through the cutout section 30a of the backup plate 30.

According to the present example, the stockers 34 are provided at two places in the vicinity of and inside the reference rail 27, the hard pins 11 are accommodated in one stocker 34, and the soft pins 12 are accommodated in the other stocker 34. When manufacturing single-sided mounting boards for which only the hard pins 11 are used, only the hard pins 11 may be accommodated in the two stockers 34. When manufacturing double-sided mounting boards for which only the soft pins 12 are used, only the soft pins 12 may be accommodated in the two stockers 34.

Incidentally, since the stockers 34 are attached to the backup plate 30, the stockers 34 are lifted as illustrated in Fig. 3(b) when the backup plate 30 is lifted to the board clamping position. Thus, it is necessary for the backup pins 11 and 12 mounted on the stocker 34 not to interfere with the formerly mounted components 32 on the circuit board 25 on the conveyors 23 and 24. As a solution to that, according to the present example, the stocker 34 is provided at a position lower than the underside of the backup plate 30 by an amount equal to or greater than the height of the formerly mounted components 32.

Next, a transferring operation of the backup pin 11 or 12 on the backup plate 30 using the chuck held on the mounting head of the component mounting machine will be described.

A traveling operation of the mounting head and an opening/closing operation of the chuck are controlled by a control device (control means) of the component mounting machine. The transferring operation of the backup pin 11 or 12 on the backup plate 30 is performed in a state in which there is no circuit board 25 above the backup plate 30. At that time, the backup plate 30 may be lifted to the board clamping position or the transferring operation of the backup pin 11 or 12 may be performed at the board unclamping position without the backup plate 30 being lifted.

In a case where the backup pin 11 or 12 on the backup plate 30 is removed and is accommodated in the stocker 34, the mounting head is caused to move above the backup pin 11 or 12 on the backup plate 30 which is a target to be removed, the gripping portion 17 of the holder portion 13 of the backup pin 11 or 12 is gripped by the chuck of the mounting head. Then, after the backup pin 11 or 12 is detached from the backup plate 30, the backup pin 11 or 12 is caused to move above an empty recessed accommodation portion 36 of the stocker 34 and is accommodated in the recessed accommodation portion 36.

In a case where a position of the backup pin 11 or 12 mounted on the backup plate 30 is shifted to another position on the backup plate 30, the backup pin 11 or 12 as a target to be shifted is gripped by the chuck. Then, after the backup pin 11 or 12 is detached from the backup plate 30, the backup pin 11 or 12 is caused to move above a target transfer position on the backup plate 30 and the backup pin 11 or 12 is lowered and mounted on the backup plate 30. In this manner, the backup pin 11 or 12 is attached and held at the target transfer position on the backup plate 30 due to a magnetic force of the magnet 18 of the holder portion 13.

In a case where the backup pin 11 or 12 accommodated in the stocker 34 is mounted on a target pin mounting position on the backup plate 30, the backup pin 11 or 12 accommodated in the stocker 34 is imaged using an imaging device (not illustrated) of the component mounting machine and a type or a position of the backup pin 11 or 12 is identified through image processing. When imaging using an imaging device, a light beam is applied from above. Since the top surface of the hard pin portion 14 and the annular top surface of the holder portion 13 shines due to reflection of a light beam thereof and is imaged, it is checked whether there is a shiny surface at the center of the top surface (annular shiny surface) of the holder portion 13 such that the hard pin 11 and the soft pin 12 may be identified.

The type or position of the backup pin 11 or 12 is identified through determination of the image processing of the shiny surface and the backup pin 11 or 12 mounted on the backup plate 30 is selected from the plurality of backup pins 11 or 12 accommodated in the stocker 34. Then, after the gripping portion 17 of the holder portion 13 of the backup pin 11 or 12 is gripped by a chuck and is raised from the stocker 34, the backup pin 11 or 12 is caused to move above the target pin mounting position on the backup plate 30 and the backup pin 11 or 12 is lowered and mounted on the backup plate 30. In this manner, the backup pin 11 or 12 is attached and held at the target pin mounting position on the backup plate 30 due to the magnetic force of the magnet 18 of the holder portion 13.

The backup pins 11 and 12 of the present example described above are configured to include the holder portion 13 on their lower side and the pin portions 14 and 15 on their upper side which are interchangeably held in the holder portion 13 such that the pin portion 14 or 15 selected from two types of pin portions 14 and 15 formed of different materials or having different shapes is used by being held in the holder portion 13. Therefore, the two types of backup pins 11 and 12 formed of different materials or having different shapes can share the holder portion 13 and it is possible to easily control the backup pins 11 and 12 such that a control cost can be reduced.

The present invention is not limited to the case in which the two types of hard and soft pin portions 14 and 15 which are interchangeably held in the holder portion 13 are provided on the upper side thereof but may include a case in which a plurality of types of soft pin portions or hard pin portions are different from each other only in shape and are formed of the same material or a case in which a plurality of types of soft pin portions are formed of different soft elastic materials (elastic coefficient).

In addition, since the gripping portion 17 which is gripped by the chuck of the mounting head of the component mounting machine is formed on the holder portion 13 of the backup pins 11 and 12 of the present example, the backup pins 11 and 12 are reliably gripped by the chuck of the mounting head of the component mounting machine such that it is possible to automatically dispose the backup pins 11 and 12 at any position on the backup plate 30.

In addition, according to the configuration of the present example, the magnet 18 that holds the holder portion 13 on the backup plate 30 is provided in the holder portion 13 of the backup pins 11 and 12 such that the backup pins 11 and 12 are attached and held on the backup plate 30 by the magnet 18 of the holder portion 13. However, as in PTL 1 and PTL 2 described above, many attachment holes may be formed on the backup plate in the shape of a matrix and a convex fitting portion may be formed on the holder portion of the backup pin to fit in the attachment hole such that an attachment hole may be selected for the convex fitting portion of the holder portion to fit therein and the backup pin may be attached to the backup plate depending on the type of board to be manufactured.

However, with this attachment structure, the arrangement of the backup pins on the backup plate is limited to the positions of the attachment holes and it is not possible to freely arrange the positions of the backup pins.

In this respect, as in the present example, when the backup pins 11 and 12 are configured to be attached and held on the backup plate 30 by the magnet 18 of the holder portion 13, it is possible to attach the backup pins 11 and 12 at any position on the backup plate 30 due to the magnetic force of the magnet 18 and it is possible to freely arrange the positions of the backup pins 11 and 12 on the backup plate 30.

In addition, in the present example, the stockers 34 which accommodate the backup pins 11 and 12 are provided on a side edge section of the backup plate 30, which is positioned inside the conveyors 23 and 24; however, a configuration in which the stockers 34 are disposed outside the conveyors 23 and 24 may be employed.

However, when the stockers 34 are disposed outside the conveyors 23 and 24, the mounting head has to travel across the rail 27 (or 28) of the conveyor 23 (or 24) when the backup pin 11 or 12 in the stocker 34 is gripped by the chuck of the mounting head of the component mounting machine and is mounted on the backup plate 30. Thus, the mounting head travels a long distance and the transfer operation of the backup pins 11 and 12 takes time. On the other hand, when the stockers 34 are disposed inside the conveyors 23 and 24, there is a possibility that a circuit board 25 will be above the stocker 34. Therefore, there is a possibility that the backup pins 11 and 12 accommodated in the stockers 34 will interfere with the formerly mounted components 32 on the circuit board 25.

In order to solve these problems, the stockers 34 are provided on the side edge section of the backup plate 30, which is positioned inside the conveyors 23 and 24, in a position that is lower than the backup plate 30. Therefore, even when the stockers 34 are provided on the side edge section of the backup plate 30 which is positioned inside the conveyors 23 and 24, it is possible to prevent the backup pins 11 and 12 accommodated in the stockers 34 from interfering with the formerly mounted components 32 on the circuit board 25. Additionally, when the stockers 34 are provided on the side edge section of the backup plate 30 which is positioned inside the conveyors 23 and 24, the mounting head does not have to travel across the rail 27 (or 28) of the conveyor 23 (or 24) and the mounting head can travel a short distance such that it is possible to shorten the time required for the transfer operation of the backup pins 11 and 12.

Further, according to the present example, since the circuit board 25 is supported by the reference rail 27, the backup pins do not have to be disposed on the backup plate 30 in the vicinity of the reference rail 27. In this respect, the stockers 34 are provided on the reference rail 27 side. Thus, it is possible to provide the stockers 34 on the backup plate 30 without substantial limitations on the arrangement of the backup pins 11 and 12 on the backup plate 30.

In addition, according to the present example, the backup pins 11 and 12 accommodated in the stocker 34 are imaged using the imaging device of the component mounting machine and types of the backup pins 11 and 12 are identified through the image processing. Thus, it is possible to reliably prevent wrong types of backup pins 11 and 12 from being mistakenly mounted on the backup plate 30.

The present invention is not limited to the examples described above. Various modifications may be performed within the scope defined by the claims. For example, the stockers 34 may be provided on side edge sections of the backup plate 30 in the conveyance direction or in a direction that is opposite of the conveyance direction of the circuit board 25, or the stockers 34 may be provided at portions other than the backup plate 30. In addition, the backup pins 11 and 12 accommodated in the stocker 34 may be not imaged using the imaging device of the component mounting machine and the image processing may not be performed. In addition, the structure of holding the pin portions 14 and 15 in the holder portions 13 may be appropriately modified.

### Reference Signs List

11, 12 ... backup pin, 13 ... holder portion, 14 ... hard pin portion (pin portion), 15 ... soft pin portion (pin portion), 16 ... fitting hole, 17 ... gripping portion, 18 ... magnet, 22 ... component mounting station, 23,24 ... conveyor, 25 ... circuit board, 27 ... reference rail, 28 ... movable rail, 30 ... backup plate, 30a ... cutout section, 31 ... lifting and lowering mechanism, 32 ... formerly mounted component, 33 ... clamping member, 34 ... stocker, 35 ... cutout section, 36 ... recessed accommodation portion

## Claims

1. A backup pin (11,12) configured to support from below a circuit board (25) on which a component is mounted at a component mounting station (22) of a component mounting machine, the backup pin (11,12) being **characterized by**:
a holder portion (13) on a lower side thereof; and
a pin portion (14, 15) on an upper side thereof which is interchangeably held in the holder portion (13),
wherein the backup pin (11,12) is configured to be used with a pin portion (14, 15) selected from a plurality of types of pin portions (14, 15) formed of different materials and/or having different shapes being held in the holder portion (13).

2. The backup pin (11,12) according to Claim 1,
wherein the pin portion (14, 15) that is holdable in the holder portion (13) is a soft pin portion (15) formed of a soft elastic material or is a hard pin portion (14) formed of a hard material.

3. The backup pin (11,12) according to Claim 1 or 2,
wherein a gripping portion (17) is formed on the holder portion (13) to be gripped by a chuck held in a mounting head of the component mounting machine.

4. The backup pin (11,12) according to any one of Claims 1 to 3,
wherein an application thereof is performed in a component mounting machine in which a backup plate (30), on which the backup pin (11,12) is placed, formed of a magnetic material is provided at the component mounting station (22), and
wherein a magnet (1 configured to hold the holder portion (13) on the backup plate (30) due to a magnetic force is provided in the holder portion (13).

5. An automatic backup pin exchange system comprising:
a stocker (34) configured to accomodate the backup pin (11,12) according to any one of Claims 1 to 4;
a backup plate (30) on which the backup pin (11,12) is placed;
a chuck held on a mounting head of the component mounting machine; and
control means for controlling a movement operation of the mounting head and an opening/closing operation of the chuck,
wherein a plurality of backup pins (11,12) according to any one of claims 1 to 4 on which different types of pin portions (14, 15) are held are accommodated in the stocker (34),
wherein the control means is configured to control an operation of gripping the backup pin (11,12) on the backup plate (30) by the chuck and accommodating the backup pins (11,12) in the stocker (34) and an operation of gripping a predetermined backup pin (11,12) by the chuck from the plurality of backup pins (11,12) accommodated in the stocker (34) and placing the backup pin (11,12) at a predetermined position on the backup plate (30).

6. The automatic backup pin exchange system according to Claim 5,
wherein the stocker (34) is provided on a side edge section of the backup plate (30) in a position that is lower than the backup plate (30).

7. The automatic backup pin exchange system according to Claim 6,
wherein an application thereof is performed in a component mounting machine in which one of the rails on both sides of a conveyor (23, 24) configured to convey a circuit board (25) is set as a reference rail (27) having a fixed position and the other rail is set as a movable rail (28) configured to move in a width direction through a width of the circuit board (25), and
wherein the stocker (34) is provided on the reference rail (27) side.

8. The automatic backup pin exchange system according to any one of Claims 5 to 7,
wherein an application thereof is performed in the component mounting machine that includes an imaging device which images an imaging target object from above, and wherein the control means is configured to cause the imaging device to image backup pins (11,12) accommodated in the stocker (34) and to identify types of the backup pins (11,12) through image processing.

## Patentansprüche

1. Sicherungsstift (11, 12) ausgebildet zum Stützen einer Leiterplatte (25) von unten, auf der eine Komponente an einer Komponentenmontagestation (22) einer Komponentenmontagemaschine montiert wird, wobei der Sicherungsstift (11, 12) **gekennzeichnet ist durch**:
einen Halterabschnitt (13) auf einer unteren Seite von diesem; und
einen Stiftabschnitt (14, 15) auf einer oberen Seite von diesem, der austauschbar im Halterabschnitt (13) gehalten wird,
wobei der Sicherungsstift (11, 12) zur Verwendung mit einem aus einer Vielzahl von aus verschiedenen Materialien gebildeten und/oder verschiedene Formen aufweisenden Arten von Stiftabschnitten (14, 15), die im Halterabschnitt (13) gehalten werden, gewählten Stiftabschnitt (14, 15) ausgebildet ist.

2. Sicherungsstift (11, 12) nach Anspruch 1,
wobei der Stiftabschnitt (14, 15), der im Halterabschnitt (13) haltbar ist, ein aus einem weichen elastischen Material gebildeter weicher Stiftabschnitt (15) ist oder ein aus einem harten Material gebildeter harter Stiftabschnitt (14) ist.

3. Sicherungsstift (11, 12) nach Anspruch 1 oder 2,
wobei ein Spannabschnitt (17) auf dem Halterabschnitt (13) zum Gespanntwerden durch eine in einem Montagekopf der Komponentenmontagemaschine gehaltene Spannvorrichtung gebildet ist.

4. Sicherungsstift (11, 12) nach einem der Ansprüche 1 bis 3,
wobei eine Anwendung von diesem in einer Komponentenmontagemaschine durchgeführt wird, in der eine Sicherungsplatte (30), auf welcher der Sicherungsstift (11, 12) angeordnet ist, gebildet aus einem magnetischen Material, an der Komponentenmontagestation (22) angeordnet ist, und
wobei ein zum Halten des Halterabschnitts (13) auf der Sicherungsplatte (30) aufgrund einer magnetischen Kraft im Halterabschnitt (13) ausgebildeter Magnet angeordnet ist.

5. Automatisches Sicherungsstift-Wechselsystem umfassend:
einen zum Aufnehmen des Sicherungsstifts (11, 12) nach einem der Ansprüche 1 bis 4 ausgebildeten Speicher (34),
eine Sicherungsplatte (30), auf welcher der Sicherungsstift (11, 12) angeordnet ist;
eine auf einem Montagekopf der Komponentenmontagemaschine gehaltene Spannvorrichtung; und
ein Steuermittel zum Steuern eines Bewegungsvorgangs des Montagekopfes und eines Öffnungs-/Schließvorgangs der Spannvorrichtung,
wobei eine Vielzahl von Sicherungsstiften (11, 12) nach einem der Ansprüche 1 bis 4, auf denen verschiedene Arten von Stiftabschnitten (14, 15) gehalten werden, im Speicher (34) aufgenommen werden,
wobei das Steuermittel zum Steuern eines Vorgangs des Spannens des Sicherungsstifts (11, 12) auf der Sicherungsplatte (30) durch die Spannvorrichtung und Aufnehmen der Sicherungsstifte (11, 12) im Speicher (34) und eines Vorgangs zum Spannen eines vorgegebenen Sicherungsstifts (11, 12) aus der Vielzahl von im Speicher (34) aufgenommenen Sicherungsstifte (11, 12) durch die Spannvorrichtung und Platzieren des Sicherungsstifts (11, 12) an einer vorgegebenen Position auf der Sicherungsplatte (30) ausgebildet ist.

6. Automatisches Sicherungsstift-Wechselsystem nach Anspruch 5,
wobei der Speicher (34) auf einem Seitenrandabschnitt der Sicherungsplatte (30) in einer Position angeordnet ist, die niedriger ist als die Sicherungsplatte (30).

7. Automatisches Sicherungsstift-Wechselsystem nach Anspruch 6,
wobei eine Anwendung von diesem in einer Komponentenmontagemaschine durchgeführt wird, in der eine der Schienen an beiden Seiten eines Förderers (23, 24) ausgebildet zum Befördern einer Leiterplatte (25) als eine Referenzschiene (27) mit einer festen Position festgelegt ist und die andere Schiene als eine bewegliche Schiene (28) ausgebildet zum Bewegen in einer Breitenrichtung durch eine Breite der Leiterplatte (25) festgelegt ist, und wobei der Speicher (34) auf der Seite der Referenzschiene (27) angeordnet ist.

8. Automatisches Sicherungsstift-Wechselsystem nach einem der Ansprüche 5 bis 7,
wobei eine Anwendung von diesem in der Komponentenmontagemaschine durchgeführt wird, die eine Bildgebungsvorrichtung umfasst, die eine Bildgebung eines Bildgebungszielobjekts von oben durchführt, und
wobei das Steuermittel zum Veranlassen der Bildgebungsvorrichtung zum Durchführen einer Bildgebung der im Speicher (34) aufgenommenen Sicherungsstifte (11, 12) und zum Identifizieren von Arten der Sicherungsstifte (11, 12) durch Bildverarbeitung ausgebildet ist.

## Revendications

1. Broche de renfort (11, 12) configurée pour supporter par le bas une carte à circuit imprimé (25) sur laquelle est monté un composant au niveau d'un poste de montage de composants (22) d'une machine de montage de composants, la broche de renfort (11, 12) étant **caractérisée par** :
une partie formant support (13) sur son côté inférieur, et
une partie broche (14, 15) sur son côté supérieur, laquelle est maintenue dans la partie formant support (13) tout en étant interchangeable,
la broche de renfort (11, 12) étant configurée pour être utilisée avec une partie broche (14, 15) sélectionnée à partir d'une pluralité de types de parties broches (14, 15) formées de différents matériaux et/ou présentant différentes formes, maintenues dans la partie formant support (13).

2. Broche de renfort (11, 12) selon la revendication 1,
dans laquelle la partie broche (14, 15) qui peut être maintenue dans la partie formant support (13) est une partie broche molle (15) formée d'un matériau élastique mou, ou bien est une partie broche dure (14) formée d'un matériau dur.

3. Broche de renfort (11, 12) selon la revendication 1 ou la revendication 2,
dans laquelle une partie de préhension (17) est formée sur la partie formant support (13) pour être saisie par un mandrin maintenu dans une tête de montage de la machine de montage de composants.

4. Broche de renfort (11, 12) selon l'une quelconque des revendications 1 à 3,
dans laquelle une application de celle-ci est effectuée dans une machine de montage de composants dans laquelle une plaque de renfort (30) sur laquelle est placée la broche de renfort (11, 12), formée d'un matériau magnétique, est disposée au niveau du poste de montage de composants (22), et
dans laquelle un aimant (1) configuré pour maintenir la partie formant support (13) sur la plaque de renfort (30) grâce à une force magnétique, est disposé dans la partie formant support (13).

5. Système automatique d'échange de broches de renfort comprenant :
un dispositif de stockage (34) configuré pour accueillir la broche de renfort (11, 12) conforme à l'une quelconque des revendications 1 à 4,
une plaque de renfort (30) sur laquelle est placée la broche de renfort (11, 12),
un mandrin maintenu sur une tête de montage de la machine de montage de composants, et
un moyen de commande permettant de piloter une manoeuvre de mouvement de la tête de montage et une manoeuvre d'ouverture ou de fermeture du mandrin,
dans lequel un certain nombre de broches de renfort (11, 12), conformes à l'une quelconque des revendications 1 à 4, sur lesquelles sont maintenus différents types de parties broches (14, 15), sont logées dans le dispositif de stockage (34),
dans lequel le moyen de commande est configuré pour piloter une manoeuvre de préhension de la broche de renfort (11, 12) sur la plaque de renfort (30) par le mandrin, et d'accueil des broches de renfort (11, 12) dans le dispositif de stockage (34), ainsi qu'une manoeuvre de préhension par le mandrin d'une broche de renfort (11, 12) prédéterminée à partir de la pluralité de broches de renfort (11, 12) logées dans le dispositif de stockage (34), et de placement de la broche de renfort (11, 12) à une position prédéterminée sur la plaque de renfort (30).

6. Système automatique d'échange de broches de renfort selon la revendication 5,
dans lequel le dispositif de stockage (34) est disposé sur une section de bordure latérale de la plaque de renfort (30) dans une position qui est plus basse que celle de la plaque de renfort (30).

7. Système automatique d'échange de broches de renfort selon la revendication 6,
dans lequel l'application de celui-ci est effectuée dans une machine de montage de composants dans laquelle l'un des rails situés sur les deux côtés d'un convoyeur (23, 24), configuré pour transporter une carte à circuit imprimé (25), est défini comme rail de référence (27) présentant une position fixe, et dans laquelle l'autre rail est défini comme rail mobile (28) dans la direction de la largeur sur toute la largeur de la carte à circuit imprimé (25), et
dans lequel le dispositif de stockage (34) est disposé sur le côté du rail de référence (27).

8. Système automatique d'échange de broches de renfort selon l'une quelconque des revendications 5 à 7,
dans lequel une application de celui-ci est effectuée par la machine de montage de composants qui inclut un dispositif de formation d'images, lequel met en image un objet cible à former en image par-dessus, et
dans lequel le moyen de commande est configuré pour amener le dispositif de formation d'images à mettre en image des broches de renfort (11, 12) logées dans le dispositif de stockage (34), ainsi qu'à identifier les types de broches de renfort (11, 12) par l'intermédiaire d'un traitement d'image.
